# EUROPEAN PATENT APPLICATION

(11) **EP 4 358 656 A1**
(43) Date of publication of application: **24.04.2024**
(21) Application number: 22202274.1
(22) Date of filing: 18.10.2022
(51) Int. Cl.: H05K 3/00, H05K 3/22, B65G 47/52

(54) **APPARATUS FOR PROCESSING COMPONENT CARRIER STRUCTURES IN A CLEAN ROOM ENVIRONMENT**

(71) Applicant: AT & S Austria Technologie & Systemtechnik Aktiengesellschaft, 8700 Leoben-Hinterberg (AT)
(72) Inventor: Pflanzl, Sandra, 8020 Graz (AT)
(74) Representative: Dilg, Haeusler, Schindelmann Patentanwaltsgesellschaft mbH

(57) **Abstract**

The present invention relates to a processing apparatus (100) for processing component carrier structures (210) The processing apparatus (100) comprises a handler (110) configured for loading a component carrier structure (210), for supplying the component carrier structure (210) to a processing chamber (101), and for unloading the component carrier structure (210) after processing in the processing chamber (101); and the processing chamber (101) configured for processing the component carrier structure (210) and having an integrated dryer device (102) for drying the component carrier structure (210) before the handler (110) removes the component carrier structure (210) from the processing chamber (101).

## Description

### Field of invention

The invention relates to a processing apparatus and a method for processing component carrier structures.

### Art Background

A component carrier, such as a printed circuit board (PCB) or a substrate, mechanically supports and electrically connects active and passive electronic components. Electronic components are mounted on the component carrier and are interconnected to form a working circuit or electronic assembly. The component carriers form large plates that are mechanically and chemically treated during a manufacturing process. However, the surfaces of the component carrier to be manufactured can be damaged by residues in the air or by electrostatic discharge (ESD). For that reason, the manufacturing process takes place under clean room condition, if possible.

Specifically, chemical treatment takes place in process chambers in which the semi-finished component carriers can be placed for the further processing. However, after a chemical treatment of the component carrier, the component carrier is wetted by chemicals so that there is a risk of contaminating the clean room condition for the further manufacturing steps.

Hence, there is an aim to provide a manufacturing line for component carrier without affecting the clean room conditions.

### Summary of the Invention

This need may be met by a processing apparatus for processing component carrier structures and a respective method according to the independent claims.

According to a first aspect, a processing apparatus for processing component carrier structures. The (e.g. fully automated) processing apparatus comprises a handler configured for loading a component carrier structure, for supplying the component carrier structure a processing chamber, and for unloading the component carrier structure after processing in the processing chamber. The processing apparatus further comprises the processing chamber configured for processing (preferably chemically and /or physically) the component carrier structure.

The processing chamber comprises an integrated dryer device for drying the component carrier structure before the handler removes the component carrier structure from the processing chamber.

According to further aspect, a method of processing a component carrier structure is described. According to the method, the component carrier structure is loaded into a processing apparatus by a handler; and the loaded component carrier structure is supplied to a processing chamber by the handler. Next, the method comprises processing (preferably chemically and /or physically) the component carrier structure in the processing chamber and after processing, drying the component carrier structure by a dryer device integrated in the processing chamber. Thereafter the component carrier structure is removed from the processing chamber by the handler and thereafter the component carrier structure is unloaded from the processing apparatus by the handler.

According to an exemplary embodiment, the processing apparatus and the method comprises the use of a panel, an array, or a component carrier, in particular a printed circuit board or an integrated circuit substrate, as the component carrier structure. In the context of the present application, a component carrier may particularly denote any support structure which is capable of accommodating one or more components thereon and/or therein for providing mechanical support and/or electrical connectivity. In other words, a component carrier of the component carrier structure may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers. The component carrier comprises a plurality of through holes that may be drilled by laser or mechanical drilling. The through holes may be later on filled with conductive material (e.g. by plating) for providing electrical connections of the component carrier. The component carrier structure comprises a plurality of component carriers that are fixed together in a common panel during the manufacturing procedure. The component carrier structure comprises one of the group consisting of a panel, a quarter panel, and an array of component carriers.

The processing apparatus may comprise a housing which houses the parts of the handler and the processing chambers and thereby separates the processing area from the surrounding manufacturing (clean) room in which clean room conditions may be provided.

The handler may comprise a robot arm for gripping the component carrier structures, e.g. by clamps or by suction cups. Furthermore, the handler may comprise magnet elements, e.g. electromagnetic elements, for generating a magnetic force for attracting and thereby temporarily fixing the component carrier structures. Furthermore, the handler may comprise conveying means, such as a roller conveyor or a belt conveyor. The handler is configured, to move a component carrier structure to be manufactured into the processing apparatus, to move further the component carrier structure to the processing chamber and after processing, to move the component carrier structure out of the processing apparatus. Specifically, as described below, a plurality of component carrier structures can be processed in the processing apparatus, so that the handler may move more than one component carrier structure at the same time.

The processing chamber is configured for treating (preferably chemically and /or physically) the component carrier structures. For example, chemicals for etching, developing, stripping or surface treatment, such as adhesion promotion (e.g. a desmear process) of the component carrier structure can be applied to the component carrier structure. For example process nozzles are installed in the process chamber that spray the respective chemical substance to the component carrier structure.

The processing chamber comprises an integrated dryer device for drying the component carrier structure before the handler removes the component carrier structure from the processing chamber. As described in further detail below, the dryer device may comprise various drying means, such as a blower and/or an ultrasonic dryer. Thus, when leaving the processing chamber and the processing apparatus, respectively, the processed component carrier structures are dry, such that a contamination of the clean room by respective chemical substances is prevented. Summarizing, chemical and solvent (e.g. liquids such as water, alcohols or esters) carryover of a component carrier structure from one processing chamber to subsequent process step is prevented by drying after a wet-chemical process.

According to a further exemplary embodiment, the dryer device comprises an ultrasonic dryer unit configured for drying the component carrier structure by ultrasonic sound. Additionally or alternatively, the dryer comprises an infrared dryer unit configured for drying the component carrier structure by heating a surface of the component carrier structure. The ultrasonic dryer unit generates pressure fluctuations in the form of ultrasound, which transforms moisture onto the component carrier structure into a fine mist. The fine mist may be exhausted out of the process chamber, for example to a condenser to collect the condensate. For example, the ultrasonic dryer unit may comprise for example a piezoelectric transducer in order to generate the ultrasonic sound. For example, a dryer unit may comprise at least one ultrasonic nozzles, in particular at least 5 or more than 10. The infrared (IR) dryer unit may heat a respective surface of the component carrier to be dried up to 60°C to 90 °C, specifically up to 70°C. By the ultrasonic dryer or the infrared dryer unit a higher drying efficiency and a fast drying is provided.

According to a further exemplary embodiment, the dryer device comprises a rotation mechanism configured for rotating the component carrier structure. Specifically, by the rotation of the component carrier structure, drying by a centrifugal force may be provided. The rotation mechanism comprises for example a carrier frame element that carries the component carrier structure. The carrier frame element is rotatable (e.g. around a horizontal or vertical axis) such that centrifugal forces are generated. As a result, due to the centrifugal forces, moisture onto the component carrier structures flows radially to the edges of the component carrier structures and further away from the component carrier structures. The component carrier structure is aligned properly to the frame in order to prevent imbalance. The rotation mechanism may rotate the component carrier structures for example with a rotational speed of 10 rpm to 2000 rpm, 50 rpm to 300 rpm, in particular 100 rpm to 200 rpm, rounds per minute (rpm). The rotation can be provided to assure that the hot gas entirely catches the component carrier structures to be dried (low speed e.g. 40rpm -100 rpm). By rotating the component carrier structure in the processing chamber, a respective chemical may be homogeneously distributed or guided to a desired surface portion of the component carrier structure. Alternatively a rotation speed can be provided to impart the droplets separation using the centrifugal force deriving from the rotation (i.e. more than 100 rpm, preferable around 500-1500 rpm). Hence, an efficient drying without thermal energy may be provided.

The carrier frame (element) may be assembled to the component carrier structure inside the processing chamber. The handler (e.g. a manipulator) may position the component carrier structure and the carrier frame element in the processing chamber so that a chemical process step and/or a drying step may be performed. One of the processing chambers may be used for also only for drying and another one only for chemical or physical treatment, such that after being processed in a processing chamber chemically or physically, the component carrier structure (e.g. together with the carrier frame) may be transported to a further processing chamber which functions as a drying.

According to a further exemplary embodiment, the dryer device comprises a blower for blowing an gas-containing medium on the component carrier structure. Specifically, the gas-containing medium may dry the component carrier structure. The blower comprises a fan for generating respective gas stream the direction to the component carrier structure in the processing chamber. Additionally, the blower may comprise a heating unit for heating the gas-containing medium to be blown to the component carrier structure. Hence, the component carrier structure can be dried efficiently, also in corners, edges and cavities of the component carrier structure. Additionally or alternatively, also the dryer unit may also comprise a vacuum pump for generating a drying gas stream in the processing chamber. Additionally or alternatively, the dryer unit may also comprise a freeze-drying unit configured for cooling the surfaces of the component carrier structure such as by a low temperature dehydration process involving freezing is provided.

Summarizing, the blower is configured to blow the gas in the processing chamber and to blow the gas against the component carrier structure. Additionally, the blower is configured to force the gas (which is humid after drying the component carrier structure) to flow away from the component carrier structure and the processing chamber, respectively. Specifically, by the blowing direction of the blower, the humid gas is forced to flow in a cooling, heating, and/or gas drying circuit, for example.

According to a further exemplary embodiment, the dryer device is configured for supplying a gas (e.g. air)-containing medium for drying the component carrier structure by flowing said gas-containing medium to the component carrier structure. Specifically, the gas-containing medium is flown to both main surfaces of the component carrier structure such that both surfaces are dried. The gas-containing medium becomes humid once the moisture has been separated from the component carrier structure and assimilated gas-containing medium. The humid gas-containing medium subsequently may be subsequently condensed and collected.

By embodiments of the present invention, several combinable ways of drying and guiding moistures away from the component carrier structure as described above. For example, flow of (hot or cold) gas-containing medium against the component carrier structure may be provided. Further, upon rotation of the component carrier structure, a drying may be provided. Furthermore, e.g. an ultrasonic dryer may be used for drying the component carrier structure. Additionally, a drying effect is generated when being rotated by a rotation mechanism and the gas-containing medium that becomes humid once the moisture has been separated from the component carrier structure is guided to a heat exchanger and from the heat exchanger to a blower. Thereby, internal circulation of gas-containing medium without the need of external drying medium can be used.

By the above described exemplary embodiment, a circulation of the gas-containing medium can be provided without needing to exhaust humid gas outside of the processing apparatus in the clean room and without needing to suck gas-containing medium from the clean room inside the processing apparatus. The humid gas-containing medium that comprises higher humidity caused by drying the component carrier structure in the processing chamber is sucked out of the processing chamber and is guided to the heat exchanger.

The heat exchanger cools the humid gas-containing medium. Therefore, the heat exchanger may use cool gas from the environment of the processing chamber and the processing apparatus. The heat exchanger may be for example a plate heat exchanger or a cross heat exchanger.

Furthermore, the heat exchanger may comprise a heat pump having a cooling/heating cycle of a respective tempering medium. Because the gas-containing medium is cooled by the heat exchanger, water condenses from the gas-containing medium. The cold dried gas-containing medium may then be used again for being blown into the processing chamber for drying the component carrier structure. Before being blown again into the processing chamber, the dried gas-containing medium may be heated up again for example by a separate heater or by a respective thermal coupling to the cooling/heating cycle of the heating pump. Hence, without needing external gas-containing medium, an internal circulation of gas-containing medium can be used by drying and heating the gas-containing medium inside the processing apparatus.

By the condensation of the humid gas-containing medium, the humid warm gas-containing medium from the processing chamber through the heat exchanger comprising an air condenser, the dry gas-containing medium can be returned to the drying cycle. The condenser may be a plate-shaped air condenser, wherein the humid warm gas from the processing chamber is blown through the gas (i.e. air) condenser, which is cooled with outside gas from the environment, i.e. the clean room, or by a cooling/heating cycle of a heat pump, blowing through the gas condenser. The water from the humid gas-containing medium condenses and the dry gas is returned to the drying circuit. The result is that a gentle drying of the component carrier structures takes place without needing external gas and without causing oxidation stains or chemical/solvent (e.g. water) stains due to the faster drying process.

The operating principle of the drying function in the processing chamber is that the cooled dried gas-containing medium is heated so that warm gas flows into the processing chamber and allows moisture to evaporate from the component carrier structure to be dried. The rotation mechanism rotates, which causes the component carrier structure to vibrate, resulting in homogeneous drying. After the heated gas is enriched and e.g. saturated with water vapor, it is blown out to the heat exchanger and thereby cooled. Moisture condenses and flows into a separate condensate container.

In order to control the drying power, respective mass flow sensors installed in the processing chamber are provided for measuring the mass flow of the gas-containing medium into the processing chamber and out of the processing chamber. Additionally, humidity sensors and temperature sensors are installed in the processing chamber in order to measure the respective humidity and temperature of the gas-containing medium. The processing chamber may also comprise at least one sensor and or a combination or several different sensors, which enable to monitor the drying status of the component carrier structure by e.g. monitoring the mass of the component carrier structure over the time or the temperature change of the component carrier structure over the time.

According to a further exemplary embodiment, the processing apparatus comprises a filter module for filtering a humid gas-containing medium generated by drying the component carrier structure. After chemical processing of the component carrier structure in the processing chamber it may happen, that small particles may be blown away by the gas-containing medium. However, the particles i.e. of solid material in the gas-containing medium may cause damage to component carrier structures if the particles are for example blown into the processing chamber with a high-pressure for drying reasons. For example, also unwanted liquid/gases (e.g. reactive compounds which may cause unwanted reaction on the surface of the component carrier) are filtered by the filter module. Therefore, before entering the processing chamber, the gas-containing medium is filtered by a filter module for removing the respective residues and particles. The filter module may comprise for example respective filtering materials, such as fabric material and fleas, respectively or a respective sieve ore strainer filter. Hence, a high-quality process environment can be provided.

According to a further exemplary embodiment, the processing apparatus comprises at least one further processing chamber. The handler is configured for supplying the component carrier structure to the at least one further processing chamber, and for unloading the component carrier structure after processing in the at least one further processing chamber. The at least one further processing chamber is configured for processing (preferably chemically and /or physically) the component carrier structure and having at least one further integrated dryer device for drying the component carrier structure before the handler removes the component carrier structure from the at least one further processing chamber. Hence, a high production volume production, i.e. a higher frequency of production can be achieved.

The processing chambers may be arranged and attached with respect to each other in a horizontal way and stacked or in a vertical way and aligned side by side.

According to a further exemplary embodiment, the processing chamber comprises an etching chamber, a developing chamber and/or a stripping chamber. For example, in an etching chamber, respective assets as chemical substances, such as hydrochloric acid, can be applied to the component carrier structures for removing specific surface sections. In a developing chamber, further layers, such as photoresist layers or other kind of place maybe applied to the surface of the component carrier structures. In the stripping chamber, specific layers, such as photoresist that are no longer required are stripped from the component carrier structures, for example by pure alkaline solutions. The processing chamber may function as a surface treatment chamber. For example, in a surface treatment chamber, roughening of the surface of a component carrier structure by using e.g. oxidation agent, e.g. permanganate comprising treatment material may be provided (i.e. a desmear process). Hence, in the processing apparatus, a high diversity of processes may be applied to the component carrier structure. Hence, the processing apparatus may form a space saving apparatus.

According to a further exemplary embodiment, the handler is configured for automatically handling the component carrier structure. The processing apparatus may comprise or may be coupled to a respective control unit for controlling the handler and the processes in the respective processing chambers. Hence, the control unit may for example control the loading of the respective component carrier structure and the conveyance of the component carrier structure to a processing chamber. Furthermore, the control unit may control the respective processing in the processing chamber, in which a component carrier structure is located. Specifically, the control unit may control several kinds of processing, such as etching, and the processing time and the injection of respective chemical substances for treating the component carrier structures, respectively. Furthermore, the control unit controls after processing the component carrier structures the handler again and move the component carrier structure to an unloader unit for moving the processed component carrier structure away from the processing apparatus. Alternatively, the handler is configured for handling the component carrier structure through the action of the operator (for example inputting a command to the apparatus or guiding mechanical actuators); in this specific embodiment, the control unit can be configured to advise the operator in case a manual intervention is necessary.

The processing chambers may be formed identically and may conduct similar treatment processes of the component carrier structures. Hence, a plurality of component carrier structures may be processes simultaneously. Alternatively, the process chambers may conduct different treating processes. Hence, the respective component carrier structure may be moved by the handler from one process chamber to a subsequent process chamber for conducting different process steps. For example, in one process chamber, a development procedure may be conducted and in a further subsequent processing chamber, an etching process may be conducted to the component carrier structure. Hence, after the final process in a final processing chamber is finished, the handler moves the respective component carrier structure away from the processing apparatus. The respective manufacturing process provided in one or a plurality of processing chambers can be controlled by the control unit. A fully automated processing procedure in the respective processing apparatus can be provided. Due to the fully automated processing procedure, also the risk of generating scrap is reduced. The control unit may be able to receive data from the sensors in order to keep monitored, and if needed to change, the working status of the dryer device, for example modifying the supply of the gas containing medium and/or the working temperature, as set to ensure a reliable drying of the component carrier structure.

According to a further exemplary embodiment, the processing chamber comprises a mounting frame for mounting the component carrier structure during processing and during drying. Hence, the component carrier structure must not be removed from respective carrier structures such that an efficient processing is provided. The mounting frame may be for example rotatable for centrifugal drying. The mounting frame may be made out of material or coated by material which resists the environment inside the processing chamber.

According to a further exemplary embodiment, the ultrasonic dryer unit and/or the infrared dryer unit is mounted on the mounting frame. Hence, since the ultrasonic dryer unit and/or the infrared dryer unit is mounted to the mounting frame and not for example to spaced apart walls of the processing chamber, the ultrasonic dryer unit and/or the infrared dryer unit is arranged closed to the component carrier structure to be dried such that the efficiency of the ultrasonic dryer and/or the infrared dryer unit is increased. Specifically, a plurality of ultrasonic dryer units and/or the infrared dryer unit may be arranged along the edges and/or corners of the component carrier structure for providing an efficient ultrasonic drying and IR heating. The component carrier structure is aligned properly to the frame in order to prevent imbalance.

According to a further exemplary embodiment, the blower is mounted on the mounting frame. Hence, since the blower is mounted to the mounting frame and not for example to spaced apart walls of the processing chamber, the blower is arranged closed to the component carrier structure to be dried such that the efficiency of the blower is increased. Specifically, a plurality of blowers may be arranged along the edges of the component carrier structure for providing an efficient drying gas containing medium. The blower can comprise a fan or similar devices configured to impart a flow on the gas. According to a preferred embodiment, the blower may comprise at least one nozzle, preferably a plurality of nozzles, to deliver/emit the drying gas containing medium. Furthermore, the blower may have several slits and air blades for directing the gas flow efficiently.

In an exemplary embodiment, the at least one nozzle used for drying may also be used as the processing nozzle configured for applying the processing liquids, e.g. etching liquid (substances).

Furthermore, the blower may be arranged in a gas inflow pipe for supplying gas-containing medium into the processing chamber and/or in a gas outflow pipe for draining off gas-containing medium out of the processing chamber, in order to generate a drying stream of gas-containing medium in the processing chamber.

According to a further exemplary embodiment, the method comprises operating the processing apparatus in a clean room. According to a further exemplary embodiment of the methods, the processing apparatus is operated in the clean room without an exchange of air and gas-containing medium, respectively, between an interior of the processing chamber and the clean room. As described above, due to the circulation of the gas-containing medium inside the processing apparatus, a contamination with the surrounding clean room is prevented or fundamentally reduced. Hence, the processing apparatus has the ability to be installed in the clean room.

In an exemplary embodiment, during processing the component carrier structures inside the processing (drying) chamber, at least one washing/rinsing step, preferable more than 5 washing steps, may be conducted. This may include the use of deionized water, preferably ultra pure (deionized) water (UPW). This may ensure higher quality and reliability of the process, since aggressive reagents and chemicals may be washed away.

Furthermore, rotation steps may be conducted for collecting the processing liquids after a processing step. Thus, the processing liquids may be collected separately to prevent (cross)contamination.

By the process nozzles, reactants (chemicals for chemical reaction and/or solvent) may be applied. After the reaction, the same process nozzles may be used for applying water for the washing step as described above. Thereby, the excess of chemicals is removed from the component carrier structure. Additionally and/or alternatively, the process nozzles are cleaned to ensure reliable performance.

Furthermore, the processing apparatus, and e.g. the processing chambers, are gas tight from the environment to prevent unintentional oxidation. Inside the processing apparatus, oxygen free gas(es) may be used e.g. nitrogen and/or argon. The chemical may be degassed (O2-free). In case that the gas containing medium comprises oxygen, oxygen may be filtered by oxygen filtering unit.

The solvent for processing the component carrier structures may comprise organic compounds (alcohols, esters, ketones) which may enhance the speed and quality of drying process.

Furthermore, the apparatus may comprise an optical inspection feature and may comprise ESD (electrostatic discharge) precaution elements.

According to a further exemplary embodiment a control device for an above-described processing apparatus is described. The control device comprises an input unit configured to receive inputs from the operator about the parameters and/or the kind of the component carrier structure to be processed. The control device further comprises a control unit (e.g. as described above) configured to receive the inputs and to manage the processing apparatus, in particular the dryer device in dependence of the inputs. The input may be input manually by an operator and/or may be received from a data basis and from measured parameters of the above-described sensors. The management of the processing apparatus comprises the management of the drying parameters, e.g. temperatures, gas flow (of the gas-containing medium), management of the eventual heat pump, etc.

The management of the processing apparatus by the control unit may comprise the adjustment of the physical features and parameters of the dryer devices, such as the amount of the gas-containing medium (i.e. through the blower flow rate management) and the opening of the (working drying) nozzles in order to change the flow and/or the speed of gas-containing medium through the nozzles, the orientation, e.g. the inclination-direction and/or the rotation, of the nozzles, etc. Alternatively, the orientation and the power/regulation of the dryer device, e.g. the ultrasonic/infrared dryers or the blowers, can be done also manually by an operator.

According to a further exemplary embodiment a dryer device for drying a component carrier structure, said dryer device being suitable to be provided in an above-described processing apparatus. The dryer device is configured to be coupled to the processing chamber to receive the handler with the component carrier structure to be dried. Specifically, the dryer device is configured to be coupled to the processing chamber to receive the frame (preferably with the rotating device suitable to rotate the component carrier structure) with the component carrier structure to be dried.

According to a further exemplary embodiment the processing chamber may comprise a surface treatment unit. The surface treatment unit i.e. an electrostatic treatment unit may be configured for treating at least one surface of the component carrier structure in order to prevent or avoid attaching material in solid and/or liquid and/or gaseous state e.g. water and/or foreign material to attach. Hence, in the processing chamber, a highly cleaned component carrier structure may be manufactured.

The aspects defined above and further aspects of the invention are apparent from the examples of embodiment to be described hereinafter and are explained with reference to these examples of embodiment.

### Brief Description of the Drawing

Fig. 1 shows a perspective view of a processing apparatus according to an exemplary embodiment of the invention.
Fig. 2 shows a schematic view of a rotation mechanism with a rotatable mounting frame according to an exemplary embodiment of the invention.
Fig. 3 shows a schematic view of a processing chamber comprising a heat exchanger according to an exemplary embodiment of the invention.
Fig. 4 shows a schematic view of a processing chamber comprising a heat exchanger comprising a heating pump according to an exemplary embodiment of the invention.

### Detailed Description

The illustration in the drawing is schematic. It is noted that in different figures, similar or identical elements or features are provided with the same reference signs or with reference signs, which are different from the corresponding reference signs only within the first digit. In order to avoid unnecessary repetitions elements or features which have already been elucidated with respect to a previously described embodiment are not elucidated again at a later position of the description.

Further, spatially relative terms, such as "front" and "back", "above" and "below", "left" and "right", et cetera are used to describe an element's relationship to another element(s) as illustrated in the figures. Thus, the spatially relative terms may apply to orientations in use which differ from the orientation depicted in the figures. Obviously all such spatially relative terms refer to the orientation shown in the figures only for ease of description and are not necessarily limiting as an apparatus according to an embodiment of the invention can assume orientations different than those illustrated in the figures when in use.

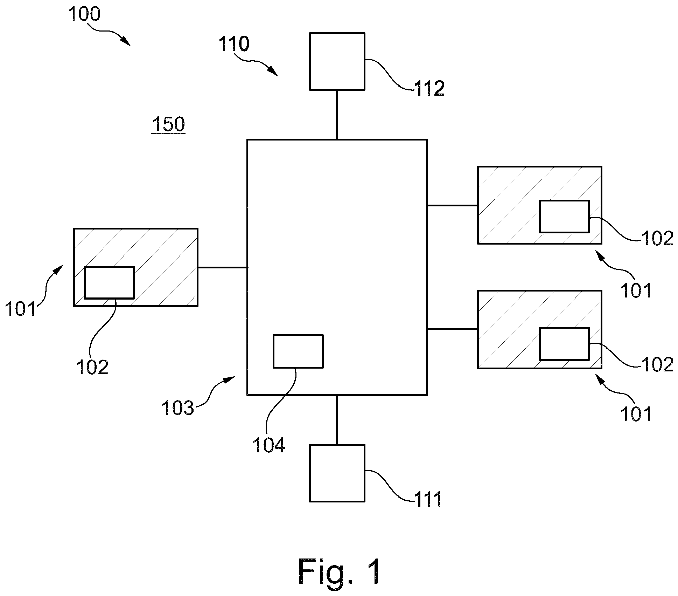

**Fig. 1** shows a perspective view of a processing apparatus 100 according to an exemplary embodiment of the invention. The processing apparatus 100 comprises a handler 110 configured for loading a component carrier structure 210, for supplying the component carrier structure 210 to a processing chamber 101, and for unloading the component carrier structure 210 after processing in the processing chamber 101. The processing apparatus 100 comprises the processing chamber 101 configured for processing (preferably chemically and /or physically) the component carrier structure 210 and having an integrated dryer device 102 for drying the component carrier structure 210 before the handler 110 removes the component carrier structure 210 from the processing chamber 101.

The processing apparatus 100 comprises a housing covering parts of the handler 110 and the processing chambers 101 and thereby separates a processing area from the surrounding manufacturing clean room 150 in which clean room conditions are provided.

The processing apparatus 100 comprises in the exemplary embodiment a handling section 103 which forms a central part of the processing apparatus 100. At a front end of the central handling section 103, respective input and output sections, for providing and taking away respective component carrier structures 210. The processing chamber 101 may be separated from the handling section 103 e.g. by a door so that during the manufacturing process (chemical reaction and/or drying) the environment of the handling section 103 is not contaminated by e.g. gas-containing the medium of the processing chamber 101. Furthermore, the atmosphere, e.g. humidity, inside the processing chamber 101 may be regenerated to initial conditions before the component carrier structure 210 is transferred into the handling section 103. The environment inside the handling section 103 may be filtered separately in order to ensure high quality manufacturing conditions.

The handler may comprise for example a loader unit 111 at the front end of the central handling section 103 for providing the component carrier structures 210. The component carrier structures 210 may be conveyed by the handler 110 along the handling section 103 to the designated processing chamber 101. The loader unit 111 and the unloader unit 112 are arranged at opposed end sections of the handling section 103. In an alternative embodiment, the processed component carrier structure 210 can be moved again to the front section of the handling section 103 and may be unloaded by an unloader unit 112 away from the processing apparatus 100. The processing chamber 101 may also comprise a closable opening so that the component carrier structure 210 is allowed to exit or enter the processing apparatus 100 or processing chamber 101 by directly exiting/entering the processing chamber 101. For example, the unloader unit 112 is directly attached to the processing chamber 101.

The handler 110 may comprise a robot arm for gripping the component carrier structures 210, e.g. by clamps or by suction cups. Furthermore, the handler 110 comprises conveying means, such as a roller conveyor or a belt conveyor for moving the component carrier structures 210 along the handling section 103. At an interface section between the handling section 103 and a respective processing chamber 101, a respective robot arm may be installed for gripping the component carrier structure 210 and for moving the component carrier structure 210 to a respective mounting frame 201 for mounting the component carrier structure inside the respective processing chamber 101. Specifically, the handler 110 is configured for handling a plurality of component carrier structures 210 in the processing apparatus 100 at the same time.

The loader unit 111 of the handler 110 is configured for automatically loading the component carrier structures 210 into the processing apparatus 100. For example, a package of stacked component carrier structures 210 may be transferred to the processing apparatus 100. From the stack of component carrier structures 210, the loading unit 111 provides the respective component carrier structures 210 one after another. For example, the loader unit 111 may comprise a respective manipulator which grips the top component carrier structure 210 of the stack and feeds the component carrier structure 210 into the processing apparatus 100, for example onto a conveyor belt of the handler 110 for the further processing. The manipulator may mechanically grip the component carrier structure 210 and/or may carry the component carrier structure 210 by suction, for example, if the manipulator comprises a suction cup for fixing the component carrier structure 210.

Accordingly, the unloader unit 112 is configured for automatically unloading the processed component carrier structures 210 out of the processing apparatus 100. The unloader unit 112 may be formed similar to the loader unit 111. The manipulator transfers the gripped component carrier structure 210 to a desired location, such as a magazine for storing a plurality of process component carrier structures 210, outside of the processing apparatus 100 for further processing.

In the exemplary embodiment shown in Fig. 1, the processing apparatus 100 comprises four processing chambers 101. The processing chambers are arranged and coupled to the handling section 103, such that the processing chambers 101 may receive the component carrier structures 210. The processing chambers 101 are arranged within a horizontal plane and are aligned side by side.

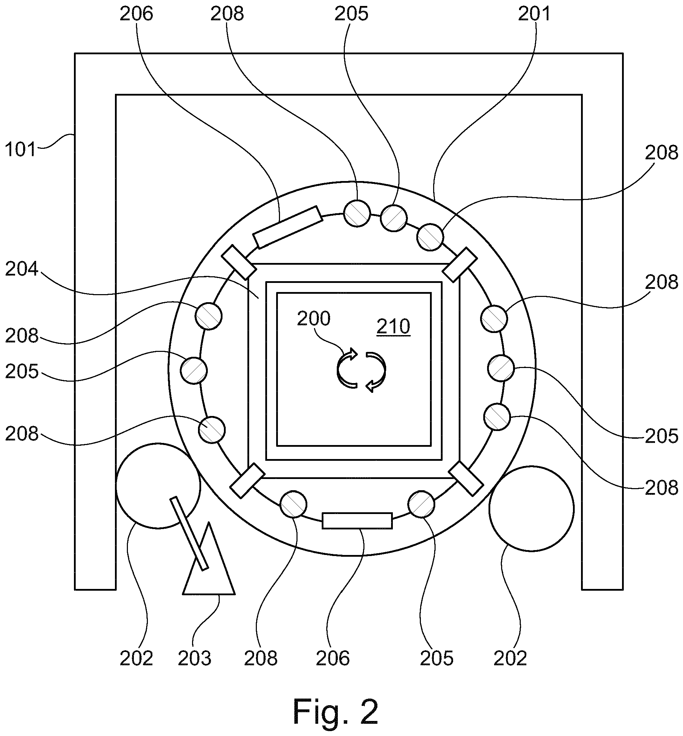

The processing chambers 101 are for example etching chambers, developing chambers or stripping chambers. The processing chambers 101 are configured for treating the component carrier structures 210. For example, process nozzles 208 (shown in Fig. 2) are installed in the process chambers 101 to spray the respective chemical substance to the component carrier structures 210.

The processing chambers 101 comprise an integrated dryer device 102 for drying the component carrier structures 210 before the handler 110 removes the component carrier structures 210 from the respective processing chamber 101. Thus, when leaving the processing chamber 101 and the processing apparatus 100, respectively, the processed component carrier structures 210 are dry, such that a contamination of the clean room 150 by respective chemical substances is prevented.

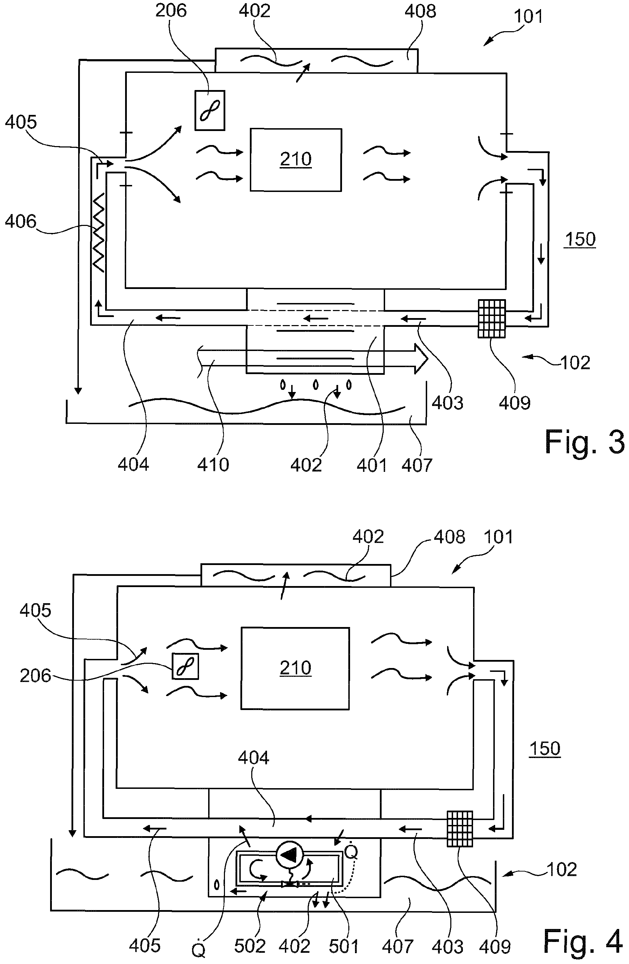

Specifically, the handler 110 is configured for automatically handling the component carrier structures 210. The processing apparatus 100 may comprise or maybe coupled to a respective control unit 104 for controlling the handler 110 and the processes in the respective processing chambers 101. Hence, the control unit 104 controls the loading of the respective component carrier structures 210 and the conveyance of the component carrier structures 210 to a processing chamber 101. Furthermore, the control unit 104 controls the respective processing in the processing chamber 101. Specifically, the control unit 104 may control the processing time and the injection of respective chemical substances for treating the component carrier structures 210, respectively. Furthermore, the control unit 104 controls after processing the component carrier structures 210 the handler again and move the component carrier structures 210 to the unloader unit 112 for moving the processed component carrier structure 210 away from the processing apparatus 100. The control unit 104 may also control the heat exchangers 401, e.g. the pump power of the heat exchangers 401 (See Fig. 4) and/or heating power of the gas(air)preheaters.

The processing chambers 101 in Fig. 1 may be formed identically and may conduct similar treatment processes of the component carrier structures. Hence, a plurality of component carrier structures 210 may be processed simultaneously. Alternatively, the process chambers 101 may provide different treating processes. Hence, the respective component carrier structure 210 may be moved by the handler 110 from one process chamber 101 to a subsequent process chamber 101 for conducting different process steps. For example, in one process chamber 101, a development procedure may be conducted and in a further subsequent processing chamber 101, an etching process may be conducted. After the final process in a final processing chamber 101 is finished, the handler 110 moves the respective component carrier structure 210 away from the processing apparatus 100. A fully automated processing procedure in the respective processing apparatus 100 can be provided.

Summarizing, by the processing apparatus 100 shown in Fig. 1, a respective processing of component carrier structures 210 in a clean room is possible. Specifically, the processing apparatus 100 is operated in the clean room 150 without an exchange of air and gas-containing medium, respectively, between an interior of the processing chamber 101 and the clean room 150.

**Fig. 2** shows a schematic view of a rotation mechanism 201 with a rotatably mounting frame 201 according to an exemplary embodiment of the invention.

The processing chamber 101 comprises the mounting frame 201 for mounting the component carrier structure 210 during processing and during drying. The mounting frame 201 comprise for example controllable clamping elements that clamps the component carrier structure 210. Specifically, a carrier frame 204 may be provided that comprises for example clamping brackets extending along an edge of the component carrier structure 210. The carrier frame 204 stabilizes the component carrier structure 210 during processing and drying. The carrier frame 204 is for example detachably fixed to the mounting frame 201.

The mounting frame 201 may comprise a circular framework as shown in Fig. 2. Specifically, the mounting frame 201 is rotatably mounted to a carrier. The mounting frame 201 is clamped to the carrier for example by respective driving wheels 202, for example similar to a planetary gear train. The driving wheels 202 are rollable along the circumferential edge of the circular mounting frame 201. By driving at least one of the driving wheels 202, the mounting frame 201 can be rotated. A respective drive unit 203 is coupled to at least one of the driving wheels 202 for driving the driving wheel 202 and hence for rotating the mounting frame 201.

Hence, the rotation mechanism 200 forms a part of the dryer device 102 configured for rotating the component carrier structure 210 for drying the component carrier structure 210 by a centrifugal force. The mounting frame 201 and the carrier frame 204, respectively, are rotatable such that centrifugal forces are generated. As a result, due to the centrifugal forces, material attached to the surface e.g. moisture and/or liquids on the component carrier structures 210 flows radially to the edges of the component carrier structures 210 and further away from the component carrier structures 210. The rotation mechanism 200 rotates the component carrier structures 210 for example with a rotational speed of 100 to 200 rounds per minute (rpm). The rotation mechanism 200 is configured for rotating the mounting frame 201 around a horizontal axis. Alternatively, the processing chamber 101 may horizontally extend. Therefore, the rotation mechanism 200 may also be configured for rotating the mounting frame 201 around a vertical axis. The rotation speed may change during the rotation process (e.g. acceleration, retardation, stop and continue).

The dryer device 102 comprises an ultrasonic dryer unit 205 configured for drying the component carrier structure 210 by ultrasonic sound. The ultrasonic dryer unit 205 generates pressure fluctuations in the form of ultrasound, which transforms moisture onto the component carrier structure 210 into a fine mist. The fine mist is exhausted out of the process chamber 101 to a condenser to collect the condensate.

The ultrasonic dryer unit 205 is mounted on the mounting frame 201 but may also be mounted to walls of the processing chamber 101. Specifically, this can be taken from Fig. 2, a plurality of ultrasonic dryer units 205 may be arranged circumferentially spaced to the mounting frame 201. Hence, since the ultrasonic dryer units 205 are mounted to the mounting frame 201, the ultrasonic dryer units 205 are arranged closed to the component carrier structure 210 to be dried such that the efficiency of the ultrasonic dryer unit 205 are increased. Ultra-sonication may be applied for a short period of time for pre-drying, e.g. less than imin, in particular less than 10sec. The ultrasonic dryer units 205 are mounted to the mounting frame 201 which may be direct contact to the component carrier structure 210 via the carrier frame 204. The ultrasonic vibration is directly transferred to the component carrier 210 which starts to vibrate. Said vibration transforms the liquid on the surface of the component carrier structure 210 into mist and/or steam which is further removed by the circulation of the gas/air. Alternatively, the ultrasonic dryer 205 is not in contact with the carrier frame 204 and the drying effect is at least partially obtained through the waves originates by the ultrasonic dryer 205.

Furthermore, the blower 206 is mounted on the mounting frame 201. Hence, since the blower 206 is mounted to the mounting frame 201, the blower 206 is arranged closed to the component carrier structure 210 to be dried such that the efficiency of the blower is increased. Specifically, a plurality of blowers 206 are arranged along the circumferential edge of the mounting frame for providing an efficient drying gas stream. The blowers 206 may comprise for example respective fans for generating the drying gas stream.

The blowers 206 blow an gas-containing medium on the component carrier structure 210 for drying the component carrier structure. Additionally, the blowers 206 may comprise a heating units for heating the gas-containing medium to be blown to the component carrier structure 210. Hence, the component carrier structure 210 can be dried efficiently.

Furthermore, process nozzles 208 are installed in the process chamber 101 that spray the respective chemical substance to the component carrier structure 210. The process nozzles 208 are monitored for example to the carrier. Upon rotating of the component carrier structure 210 by the mounting frame 201, the process nozzles 208 homogeneously cover the surfaces of the component carrier structures 210 with respective chemical substances. The process nozzles 208 may be adjustable, for example by a servo motor for nozzle movement, in order to adjust the spring direction of the process nozzles 208.

**Fig. 3** shows a schematic view of a processing chamber comprising a heat exchanger 401 according to an exemplary embodiment of the invention. The dryer device 102 is configured for supplying a humid gas-containing medium 403 generated by the component carrier structure 210 to be dried, preferably when being rotated by the rotation mechanism 200 to the heat exchanger 401, and from the heat exchanger 401 to the blower 206 for drying the component carrier structure 210 by blowing the dried gas-containing medium 405 to the component carrier structure 210. The blower 206 may also be arranged upstream of the the heat exchanger 401.

Thereby, a circulation of the gas-containing medium 403, 404, 405 is provided without needing to exhaust humid gas outside of the processing apparatus 100 in the clean room 150 and without needing to suck gas-containing medium from the clean room 150 the processing apparatus 100.

The humid gas-containing medium 403 that comprises higher humidity caused by drying the component carrier structure 210 in the processing chamber 101 is sucked out of the processing chamber 101 and is guided to heat exchanger 401. The heat exchanger 401 cools the humid gas-containing medium 403.

As shown in the exemplary embodiment in Fig. 3, the heat exchanger 401 may use cool external gas 410 from the environment of the processing chamber 101 and the processing apparatus 100, respectively. The heat exchanger 401 is example a plate heat exchanger or a cross heat exchanger.

Because the heat exchanger 401 cools the heated humid gas-containing medium 403 to a cooled gas-containing medium 404, condensate 402 of the humid gas-containing medium 403 can condensate such that cooled dried gas cooling medium 404, having a lower humidity than the more humid gas-containing medium 403, can be used again for drying the component carrier structure 210. Therefore, the heat exchanger 401 may comprise condenser elements, such as an gas cooled condenser plate. The external gas 410 from the clean room 150 is used but not mixed with the humid gas-containing medium 403 such that no contamination of the external gas 410 is caused. By the heat exchangers, only heat thermal energy is transferred.

Before the cooled gas-containing medium 404 is blown into the processing chamber 101 again, a heater 406 may be passed such that dry and heated gas contained medium 405 is generated in order to have improved drying conditions for drying the component carrier structure 210.

In order to collect the condensate 201, a condensate container 407 is provided below the heat exchanger 401. Additionally, further condensate container 408 may be arranged above of the processing chamber 101 and also along sidewalls of the processing chamber 101. Hence, by using the rotation mechanism 204 providing a centrifugal force drying, the respective condensate and process liquid generated at the top and sidewalls of the processing chamber 101 may be collected and pumped into the condensate (or process liquid) containers 407 and 408. If process liquid is gathered by the containers 407, 408, the process liquid may be reused for in further steps, e.g. in recycling steps. The processing liquid, which is applied to the component carrier structures 210 may contain chemicals e.g. acid, bases, oxidation agents. It is preferred that the condensed humidity is prevented from being mixed with process chemistry. Hence, the processing liquid may be collected in first units of containers 407, 408 and the condensate may be collected in separate second units of containers 407, 408.

Hence, the humid warm gas-containing medium 403 from the processing chamber 101 is guided through the heat exchanger 401 comprising an gas condenser, so that the dry gas-containing medium 405 can be returned to the drying cycle. The result is that a gentle drying of the component carrier structures 210 takes place without needing external gas to be blown in or out of the processing chamber 101.

Furthermore, the processing apparatus 100 comprises a filter module 409 for filtering a humid gas-containing medium 403 generated by drying the component carrier structure 210. After chemical processing of the component carrier structure in the processing chamber it may happen, that small particles may be blown away by the gas-containing medium 403, 404, 405. However, the particles in the gas-containing medium 403, 404, 405 may cause damage to component carrier structures 210 if the particles are for example blown into the processing chamber 101 with a high-pressure for drying reasons. Therefore, before entering the processing chamber 101, the gas-containing medium 403, 404, 405 is filtered by a filter module 409 for removing the respective residues and particles. A respective pump (further blower) may be arranged in a gas inflow pipe for supplying gas-containing medium into the processing chamber 101 and/or in a gas outflow pipe for draining off gas-containing medium out of the processing chamber 101, in order to generate a flow through the filter module 409.

**Fig. 4** shows a schematic view of a processing chamber 101 having similar elements and features as the processing chamber 101 shown in Fig. 3 but comprising a heat exchanger 401 with a heat pump 501 according to an exemplary embodiment of the invention. The heat pump 501 having a cooling/heating cycle 502 of a respective tempering medium, such as R410A. Furthermore, the heat pump 501 comprises a respective pump for pumping and pressurizing the tempering medium in the cooling/heating cycle 502. Furthermore, a respective expansion valve is installed in the cooling/heating cycle 502 four providing the function of each pump 501. Additionally, between the cooling/heating cycle 502 and the gas-containing medium 403, 404, for example a plate heat exchanger, a counter current heat exchanger or a cross heat exchanger may be installed in order to provide an efficient heat transfer.

Because the humid gas-containing medium 403 drained off from the processing chamber 101 is cooled by the heat exchanger 401, water condenses from the humid gas-containing medium 403. Thereby, the tempering medium of the heat pump 501 heats up. The cold dried gas-containing medium 404 may then be used again for being blown into the processing chamber for drying the component carrier structure.

Before being blown again into the processing chamber 101, the dried gas-containing medium 404 is heated up again for example by a separate heater or by a respective thermal coupling to the cooling/heating cycle 502 of the heat pump 501. Hence, the drying efficiency of the dry and heated gas-containing medium 405 is improved. Due to the circulation of the gas-containing medium 403, 404, 405 inside the processing apparatus 100, a contamination of the surrounding clean room 150 is prevented.

It should be noted that the term "comprising" does not exclude other elements or steps and the "a" or "an" does not exclude a plurality. Also elements described in association with different embodiments may be combined. It should also be noted that reference signs in the claims shall not be construed as limiting the scope of the claims. Implementation of the invention is not limited to the preferred embodiments shown in the figures and described above. Instead, a multiplicity of variants are possible which use the solutions shown and the principle according to the invention even in the case of fundamentally different embodiments.

**Reference Numerals:**

| | |
|---|---|
| 100 processing apparatus | 401 heat exchanger |
| 101 processing chamber | 402 condensate |
| 102 dryer device | 403 gas-containing medium |
| 103 handling section | 404 cooled gas-containing medium |
| 104 control unit | 405 reheated gas-containing medium |
| | 406 heater |
| 110 handler | 407 condensate container |
| 111 loader unit | 408 further condensate container |
| 112 unloader unit | 409 Filter module |
| | 410 external gas |
| 150 clean room | |
| | 501 heat pump |
| 200 rotation mechanism | 502 cooling/heating cycle |
| 201 mounting frame | |
| 202 driving wheel | |
| 203 drive unit | |
| 204 carrier frame | |
| 205 ultrasonic dryer unit | |
| 206 blower | |
| 208 process nozzle | |
| 210 component carrier structure | |

## Claims

1. A processing apparatus (100) for processing component carrier structures (210), wherein the processing apparatus (100) comprises:
a handler (110) configured for loading a component carrier structure (210), for supplying the component carrier structure (210) to a processing chamber (101), and for unloading the component carrier structure (210) after processing in the processing chamber (101); and
the processing chamber (101) configured for processing the component carrier structure (210) and having an integrated dryer device (102) for drying the component carrier structure (210) before the handler (110) removes the component carrier structure (210) from the processing chamber (101).

2. The processing apparatus (100) according to claim 1, wherein the dryer device (102) comprises an ultrasonic dryer unit (205) configured for drying the component carrier structure (210) by ultrasonic waves, and/or
wherein the dryer (102) comprises an infrared dryer unit configured for drying the component carrier structure (210) by heating a surface of the component carrier structure (210).

3. The processing apparatus (100) according to claim 1 or 2, wherein the dryer device (102) comprises a rotation mechanism (200) configured for rotating the component carrier structure (210).

4. The processing apparatus (100) according to any of claims 1 to 3, wherein the dryer device (102) comprises a blower (206) for blowing a gas-containing medium in the processing chamber.

5. The processing apparatus (100) according to any of claims 1 to 4, wherein the dryer device (102) is configured for supplying a gas-containing medium (403) for drying the component carrier structure (210) by flowing said gas-containing medium to the component carrier structure (210).

6. The processing apparatus (100) according to any of claims 1 to 5, comprising a filter module (409) for filtering a humid gas-containing medium (403) generated by drying the component carrier structure (210).

7. The processing apparatus (100) according to any of claims 1 to 6, further comprising
at least one further processing chamber (101);
wherein the handler (110) is configured for supplying the component carrier structure (210) to the at least one further processing chamber (101), and for unloading the component carrier structure (210) after processing in the at least one further processing chamber (101);
wherein the at least one further processing chamber (101) is configured for processing the component carrier structure (210) and having at least one further integrated dryer device (102) for drying the component carrier structure (210) before the handler (110) removes the component carrier structure (210)

8. The processing apparatus (100) according to any of claims 1 to 7, wherein the handler (110) is configured for automatically handling the component carrier structure (210).

9. The processing apparatus (100) according to any of claims 1 to 8, wherein the processing chamber (101) comprises a mounting frame (201) for mounting the component carrier structure (210) during processing and during drying.

10. The processing apparatus (100) according to claims 2 and 9, wherein the ultrasonic dryer unit (205) is mounted on the mounting frame (201).

11. The processing apparatus (100) according to claims 4 and 9, wherein the blower (206) is mounted on the mounting frame (201).

12. A control device for a processing apparatus according to any one of claims 1 to 11, comprising
an input unit configured to receive inputs from the operator about the parameters and/or the kind of the component carrier structure (210) to be processed, and
a control unit (104) configured to receive said inputs and to manage said processing apparatus, in particular the dryer device (102), in dependence of said inputs.

13. A dryer device (102) for drying a component carrier structure (210), said dryer device (102) being suitable to be provided in a processing apparatus (100) according to any of claims 1 to 11.

14. A method of processing a component carrier structure (210), wherein the method comprises:
loading the component carrier structure (210) into a processing apparatus (100) by a handler (110);
supplying the loaded component carrier structure (210) to a processing chamber (101) by the handler (110);
processing the component carrier structure (210) in the processing chamber (101);
after processing, drying the component carrier structure (210) by a dryer device (102) integrated in the processing chamber (101);
thereafter removing the component carrier structure (210) from the processing chamber (101) by the handler (110); and
thereafter unloading the component carrier structure (210) from the processing apparatus (100) by the handler (110).

15. The method according to claim 14, wherein the method comprises operating the processing apparatus (100) in a clean room (150),
wherein the method comprises in particular operating the processing apparatus (100) in the clean room (150) without an exchange of gas between an interior of the processing chamber (101) and the clean room (150).
